(19) Europäisches Patentamt
European Patent Office
Office européen des brevets

(11) **EP 2 762 909 A2**

(12) **EUROPEAN PATENT APPLICATION**

(43) Date of publication:
**06.08.2014 Bulletin 2014/32**

(51) Int Cl.:
***G01R 31/36*** (2006.01)

(21) Application number: **14154018.7**

(22) Date of filing: **05.02.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **05.02.2013 KR 20130012886**

(71) Applicant: **Samsung SDI Co., Ltd.**
**Yongin-si, Gyeonggi-do (KR)**

(72) Inventors:
- **Shim, Young-Woo**
**Gyeonggi-do (KR)**
- **Lee, Soo-Jin**
**Gyeonggi-do (KR)**
- **Cho, Young-Shin**
**Gyeonggi-do (KR)**

(74) Representative: **Walaski, Jan Filip et al**
**Venner Shipley LLP**
**200 Aldersgate**
**London**
**EC1A 4HD (GB)**

(54) **Battery management system and driving method thereof**

(57) A battery management system for effectively and accurately estimating a state of charge (SOC) of a battery is disclosed. In one aspect, the battery management system includes a main controller unit (300) configured to receive current and voltage data from a sensing unit (200) and calculate an open circuit voltage (OCV) upon determining that a sum of integrated current values exceeds a predetermined value. The battery management system is further configured to estimate the SOC based on the calculated OCV.

FIG. 2

20

EP 2 762 909 A2

**EP 2 762 909 A2**

**Description**

The disclosed technology generally relates to a battery management system and a method of using the same. More particularly, the disclosed technology relates to a battery management system for effectively and accurately estimating a state of charge (SOC) of a battery.

Hybrid and electric vehicles have high capacity battery packs that include secondary battery modules and secondary battery cells organized in series and parallel. In part based on a growing demand for these vehicles, technologies relating to high-power and high-energy secondary batteries using non-aqueous electrolytes have advanced tremendously. A plurality of high-power secondary battery cells can be connected in series or in parallel to form a high-capacity secondary battery module, which in turn can be assembled into a high-capacity battery pack. A battery cell is the smallest unit that can be integrated into a battery module, which typically includes several battery cells. A battery pack in turn typically includes several battery modules. While the battery management system disclosed herein can be applied at any level of integration, for simplicity, an integrated unit of battery cells is simply referred to hereinafter as a "battery."

In order to maintain an optimized operational state of the batteries, a battery management system (BMS) is often employed to manage the charging and discharging of the batteries through monitoring voltage and current.

One parameter that characterizes the present battery capacity as a percentage of maximum capacity is state-of charge (SOC). SOC is generally calculated through current integration to monitor changes in battery capacity over time. Some battery management systems estimate the SOC based on an open circuit voltage (OCV). However, measuring an exact OCV can take a minimum of five hours or more. In addition, current is measured using current sensors, which are often prone to errors in measurement. Furthermore, measurement errors can propagate through repeated charging and discharging of the batteries, thereby limiting the accuracy of the estimated SOC. Thus, there is a need for a battery management system that estimates the SOC of a battery more efficiently and more accurately.

Embodiments relate to a battery management system (BMS) for effectively and accurately estimating a state of charge (SOC) of a battery, and a method of using the same. In one aspect, the battery management system includes a main controller unit configured to receive current and voltage data from a sensing unit and calculate an open circuit voltage (OCV) upon determining that a sum of integrated current values exceeds a predetermined value. The battery management system is further configured to estimate the SOC based on the calculated OCV.

According to one embodiment of the BMS, a battery management system includes a sensing unit configured to obtain current data and voltage data by measuring current and voltage of a battery and a main controller unit (MCU) configured to receive the current and voltage data from the sensing unit, to calculate an open circuit voltage (OCV) when a sum of absolute integrated current values exceeds a predetermined value, and to estimate a state of charge (SOC) corresponding to the calculated OCV.

According to another embodiment of the BMS, the current data includes charging current and discharging current, and the sum of absolute integrated current values is a sum of absolute values of integrated charging current and integrated discharging current.

According to another embodiment of the BMS, when the sum of absolute integrated current values exceeds the predetermined value, the MCU is configured to reset to zero an integrated current value obtained by integrating the current data.

According to another embodiment of the BMS, the MCU includes a current integration unit configured to calculate an integrated current value by integrating the current data and to calculate the sum of absolute integrated current values. The MCU additionally includes an OCV calculation unit configured to calculate the OCV using the current data, the voltage data and an internal resistance of the battery, when the sum of absolute integrated current values exceeds the predetermined value. The MCU further includes an SOC estimation unit configured to estimate the SOC, using the calculated OCV.

According to another embodiment of the BMS, the OCV calculation unit is configured to calculate the OCV using at least one of the current data and the voltage data obtained using current and voltage measured at a time when the battery is substantially fully charged.

According to another embodiment of the BMS, the OCV calculation unit is configured to calculate the OCV using at least one of the current data and the voltage data obtained using current and voltage measured at a time when the battery is in a state of being charged to 90% or more relative to a fully charged state of the battery.

According to another embodiment of the BMS, the sensing unit is further configured to obtain temperature data by measuring a battery temperature.

According to another embodiment of the BMS, the OCV calculation unit is configured to determine the internal resistance using the temperature data obtained from the battery in a state in which a depth of discharge (DOD) of the battery is between about o and about 0.85 and based on temperature-resistance relationship data stored in the MCU and the internal resistance.

According to another embodiment of the BMS, the MCU further includes a current integration reset unit configured to reset the integrated current value to zero.

According to another embodiment of the BMS, the SOC estimation unit is configured to estimate the SOC based on the calculated OCV and SOC-OCV relationship data stored in the SOC estimation unit.

According to another embodiment of the BMS, when the sum of absolute integrated current values does not exceed the predetermined value, the SOC estimation unit estimates the SOC using the integrated current value.

According to another embodiment of the BMS, the SOC estimation unit estimates the SOC by adding the integrated current value to a predetermined initial SOC or a previously measured SOC.

According to another embodiment of the BMS, the predetermined value is between about five and seven times a battery capacity of the battery.

A method of using a battery management system (BMS) according to one aspect comprises receiving current data and voltage data of a battery, calculating a sum of absolute integrated current values based on the current data, calculating an open circuit voltage (OCV) upon determining that the sum of absolute integrated current values exceeds a predetermined value, using the current data, the voltage data and an internal resistance of the battery; and estimating a state of charge (SOC) corresponding to the calculated OCV.

According to another embodiment, the method includes calculating the sum of absolute integrated current values includes calculating an integrated current value by integrating the current data.

According to another embodiment, the method further includes resetting the integrated current value to zero, when the sum of absolute integrated current values exceeds the predetermined value.

According to another embodiment, at least one of the current data and voltage data for calculating the OCV is obtained using current or voltage measured at a time when the battery is substantially fully charged.

According to another embodiment, the method further includes estimating the SOC using the integrated current value, when the sum of absolute integrated current values does not exceed the predetermined value.

As described above, in certain embodiments, it is possible to calculate a more exact SOC even when errors of integrated current values are accumulated.

Embodiments of the invention will now be described by way of example with reference to the accompanying drawings, in which:

FIG. 1 is a three dimensional illustration of a battery according to one embodiment.
FIG. 2 is a block diagram schematically illustrating the battery management system of FIG. 1 in detail.
FIG. 3 is a graph illustrating a relationship between internal resistance and depth of discharge (DOD) of the battery.
FIG. 4 is a graph illustrating a relationship between open circuit voltage (OCV) and state of charge (SOC).
FIG. 5 is a flowchart illustrating a method of using the battery management system.

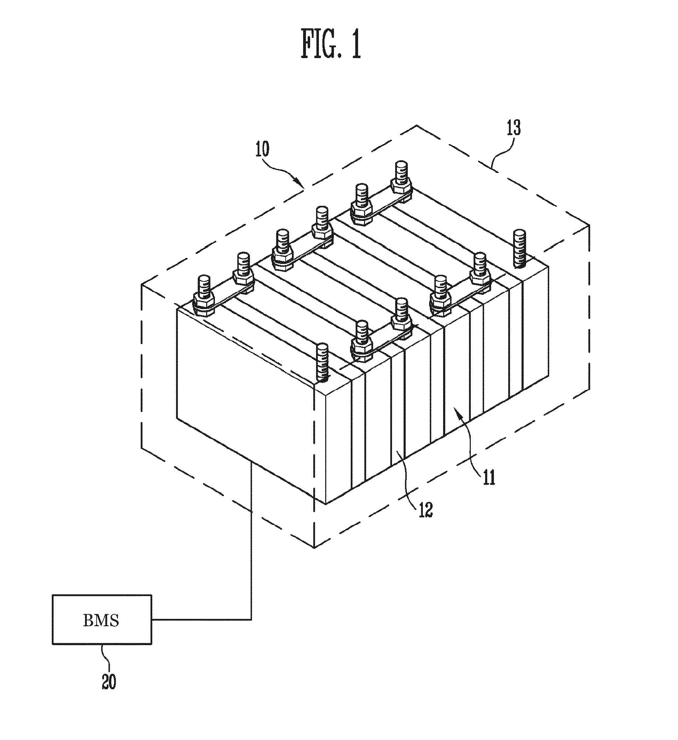

FIG. 1 illustrates a large capacity battery module 10, which includes a plurality of secondary battery cells 11 arranged at intervals, and a housing 13 configured to maintain the temperature of the battery module 10 by using a coolant. A battery management system (BMS) 20 is connected to the battery module 10 and is configured to manage charging/discharging of the battery module 10, also referred to herein as a battery.

The battery module 10 additionally includes battery barriers 12 interposed between adjacent secondary battery cells 11. The battery barrier 12 performs a cooling function by allowing air flow between the secondary battery cells 11, and performs a structural function of supporting the side surfaces of each secondary battery cell 11.

Although the secondary battery cells illustrated in FIG. 1 have a rectangular shape, other shapes and forms are possible. For example, the secondary battery cell 11 can have a cylindrical shape or any other suitable shape.

The BMS 20 is configured to detect and manage current and voltage of each secondary battery cell 11 in the battery module 10.

The BMS 20 receives data from current and voltage sensors mounted in the battery module 10. The BMS 20 stores data previously obtained by mapping a relationship between an open circuit voltage and a state of charge (SOC) to a table, and accordingly, it is possible to estimate the SOC from a measurement value obtained by the sensors.

Some BMSs estimate an actual SOC by calculating an initial SOC of the battery, calculating an integrated current value by integrating measured charging and/or discharging current over time period starting from an initial time when charging/discharging of the battery starts, and adding the resulting integrated current value to the initial SOC. It will be understood that the partial integrals over the time period can be positive or negative depending on whether integration is performed over a charging cycle or a discharging cycle. This is because the charging current measured in a charging cycle of the battery has a positive (+) value, and the discharging current measured in a discharging cycle of the battery has a negative (-) value according to common conventions. In addition, if the values of integrated charging current and integrated discharging current have the same absolute value, the integrated current value is zero.

These methods that rely on actual SOC, however, can lead to inaccurate SOC values. This is because the current of the battery is measured by current sensors. Errors can be introduced in the measured value by the current sensors. Furthermore, when the battery is used for a long period of time, especially during which period the charging/discharging of the battery is not performed completely, errors in integrated current values can propagate. The propagated errors proportionally lower the accuracy of the estimated SOC.

To improve the accuracy of the estimated SOC, the BMS 20 according to an embodiment calculates an OCV using measured current and voltage values of the battery cell 10 when a sum of absolute values of the integrated charging current and the integrated discharging current exceeds a predetermined value. The SOC is then estimated based on the calculated OCV. Additionally, the BMS 20 initializes the integrated current value, and corrects an error of the estimated SOC.

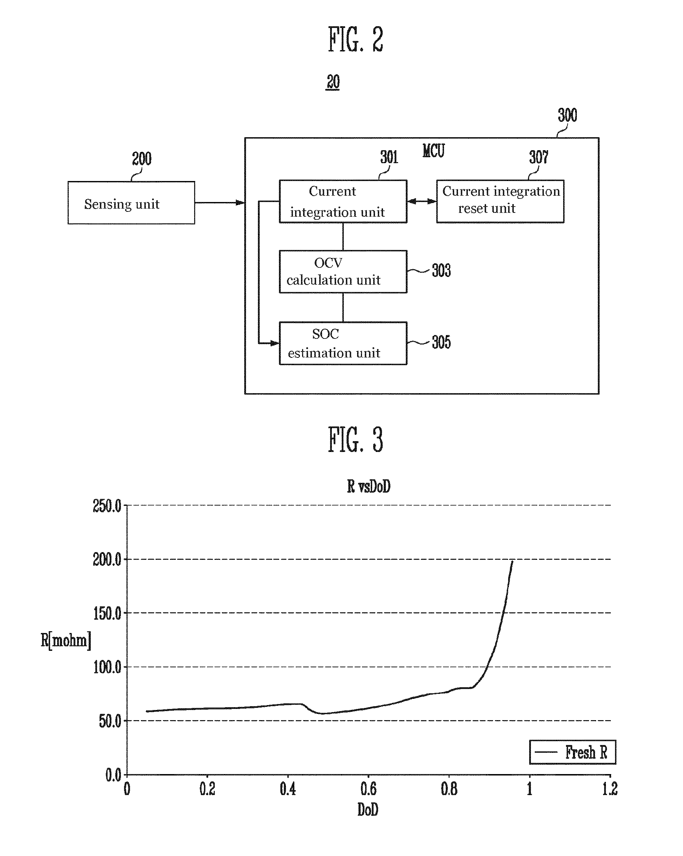

FIG. 2 is a block diagram schematically illustrating the BMS shown in FIG. 1.

As shown in FIG. 2, the BMS 200 includes a sensing unit 200 and a main controller unit (MCU) 300.

The sensing unit 200 obtains current data, voltage data and temperature data by measuring the output current, the voltage and the temperature of the battery using a current sensor, a voltage sensor and a temperature sensor, respectively, and transmits the obtained data to the MCU 300.

Here, the current data may include charging current having a positive (+) value and discharging current having a negative (-) value.

In one embodiment, the MCU 300 includes a current integration unit 301, an OCV calculation unit 303, an SOC estimation unit 305 and a current integration reset unit 307.

The current integration unit 301 calculates an integrated current value by integrating current data and also calculates a sum of absolute integrated current values.

More specifically, the sum of absolute integrated current values refers to a sum of absolute values of integrated charging current and integrated discharging current.

In a case where the sum of absolute integrated current values exceeds a predetermined value, the OCV calculation unit 303 calculates an OCV using current data, voltage data and an internal resistance of the battery.

Here, the predetermined value can be exceeded when the SOC estimated using the integrated current value is inaccurate due to the propagated errors in integrated current values. The predetermined value may be experimentally calculated.

According to an embodiment, the predetermined value may be about five to about seven times the capacity of the battery. Preferably, the predetermined value may be about six times the capacity of the battery.

That is, in a case where the sum of absolute integrated current values is about six times the capacity of the battery, the OCV calculation unit 303 determines that the accuracy of the SOC estimated using the integrated current value is low, and newly calculates an OCV.

Here, the OCV may be calculated by the following Equation 1.

$$V_{ocv} = V_{cell} - I_{cell}R_O \qquad (1)$$

Here, $V_{ocv}$ denotes an OCV, $V_{cell}$ denotes output voltage data of the battery, $I_{cell}$ denotes output current data, and $R_o$ denotes an internal resistance of the battery.

According to an embodiment, at least one of the current data and voltage data for calculating the OCV may be obtained using current or voltage measured just prior to the battery being fully charged, at a time when the battery is substantially fully charged.

The reason for calculating the OCV based on the current data and voltage data measured just prior to the battery being fully charged is because when the battery is substantially fully charged, the charging current is considerably lower than when the battery is substantially discharged. That is, according to Equation 1, the error in calculating the OCV decreases as the value of current data decreases. Thus, the OCV calculation unit 303 calculates an OCV using the current data and voltage data measured just prior to the battery being fully charged.

In some embodiments, with respect to the time when the OCV is calculated, the battery can be considered to be substantially fully charged when the battery is charged to 90% or more of its capacity, as compared with a fully-charged battery.

According to an embodiment, the internal resistance of the battery for calculating the OCV refers to a resistance determined using temperature data obtained at an arbitrary point in a region in which a depth of discharge (DOD) of the battery is o to about 0.85 and relationship data between the temperature previously stored in the MCU 300 and the internal resistance. Preferably, the internal resistance may be a resistance determined in a state in which the DOD of the battery is 0.4. As used herein, the DOD refers to the percentage of battery capacity that has been discharged, expressed as a percentage of maximum capacity. The DOD is related to SOC by the following Equation 2.

$$SOC[\%]=(1-DOD)*100 \qquad\qquad (2)$$

Here, the DOD has a range of 0 to 1. That is, the DOD in a fully-charged battery has a value of about 0, and the DOD in a fully-discharged battery has a value of about 1.

FIG. 3 is a graph illustrating a relationship between internal resistance and DOD of the battery according to an embodiment.

Referring to FIG. 3, the internal resistance in the region in which the DOD is 0 to about 0.85 follows a substantially linear relationship with DOD and does not vary substantially over that range. Further, it has a smaller value than that when the DOD exceeds 0.85. Correspondingly, the error in the calculated OCV is lower.

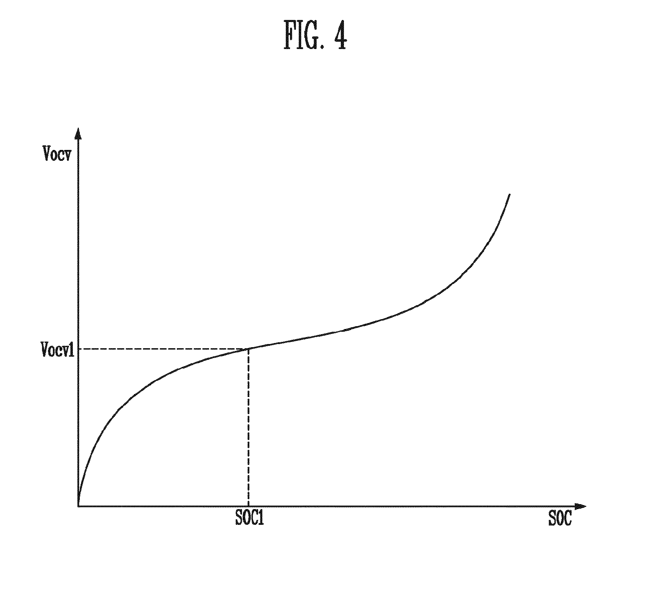

The SOC estimation unit 305 estimates an SOC in the relationship data between SOC and OCV, using the OCV input from the OCV calculation unit 303. Specifically, the SOC estimation unit 305 may store relationship data previously obtained by experimentally evaluating the relationship between OCV and SOC. The relationship is shown in the graph of FIG. 4. As shown in FIG. 4, the SOC estimation unit 305 detects an SOC SOC1 corresponding to the OCV Vocv1 input from the OCV calculation unit 303.

The current integration reset unit 307 resets the integrated current value to zero when the sum of absolute integrated current values exceeds a predetermined value.

Subsequently, the SOC estimation unit 305 estimates the SOC by adding the integrated current value to the previously estimated SOC using the integrated current value until the sum of absolute integrated current values exceeds the predetermined value.

That is, in order to avoid using an estimated SOC obtained using an integrated current value that may suffer from a large amount of propagated errors, the BMS of the disclosed technology newly calculates an OCV and estimates an SOC using the calculated OCV. In addition, the BMS resets the integrated current value to zero, so that it is possible to minimize the propagation of errors in the integrated current value.

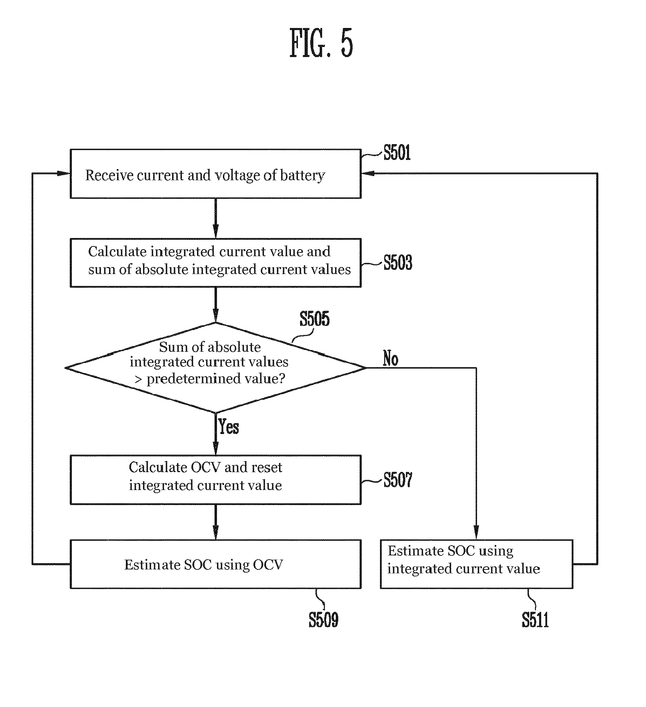

FIG. 5 is a flowchart illustrating a method of using the BMS according to an embodiment of the disclosed technology.

As shown in FIG. 5, the MCU 300 receives current data and voltage data of a battery, obtained from the sensing unit 200 (S501).

The current integration unit 301 calculates an integrated current value obtained by accumulating the current data and also calculates a sum of absolute integrated current values (S503).

The MCU 300 decides whether the sum of absolute integrated current values exceeds a predetermined value (S505).

Here, the predetermined value can be exceeded when the SOC estimated using the integrated current value is inaccurate due to propagated errors in integrated current values. The predetermined value may be experimentally calculated.

In a case where the sum of absolute integrated current values exceeds the predetermined value, the OCV calculation unit 303 calculates an OCV, using current data, voltage data and internal resistance of the battery (S507). The current integration reset unit 307 resets the integrated current value to zero.

In this case, at least one of the current data and voltage data for calculating the OCV may be a value obtained at the time just before the battery is fully charged.

The SOC estimation unit 305 estimates an SOC from relationship data between SOC and OCV, using the calculated OCV (S509).

In a case where the sum of absolute integrated current values does not exceed the predetermined value, the SOC estimation unit 305 estimates the SOC using the initial SOC or previously estimated SOC and the integrated current value (S511).

As described above, according to embodiments of the present invention, when the sum of absolute integrated current values is no less than a predetermined value, the BMS calculates an OCV and estimates an SOC, thereby preventing an estimation error caused by the propagation of errors in the integrated current value. Further, it is possible to calculate the OCV having a small error, using current data and voltage data at the time just before the battery is fully charged. Accordingly, it is possible to estimate a more exact SOC.

While the invention has been described in connection with certain exemplary embodiments, it is to be understood that the invention is not limited to the disclosed embodiments, but, on the contrary, is intended to cover various modifications and equivalent arrangements included within the scope of the appended claims.

**Claims**

1. A battery management system, comprising:

   a sensing unit configured to obtain current data and voltage data by measuring current and voltage of a battery; and
   a controller MCU configured to receive the current and voltage data from the sensing unit, to calculate an open circuit voltage OCV when a sum of absolute integrated current values exceeds a predetermined value, and to estimate a state of charge SOC corresponding to the calculated OCV.

2. The battery management system of claim 1, wherein the current data includes charging current and discharging current, and wherein the sum of absolute integrated current values is a sum of absolute values of integrated charging current and integrated discharging current.

3. The battery management system of claim 1 or 2, wherein, when the sum of absolute integrated current values exceeds the predetermined value, the controller is configured to reset to zero an integrated current value obtained by integrating the current data.

4. The battery management system of claim 1, 2 or 3, wherein the controller includes:

   a current integration unit configured to calculate an integrated current value by integrating the current data and to calculate the sum of absolute integrated current values;
   an OCV calculation unit configured to calculate the OCV using the current data, the voltage data and an internal resistance of the battery, when the sum of absolute integrated current values exceeds the predetermined value; and
   an SOC estimation unit configured to estimate the SOC, using the calculated OCV.

5. The battery management system of claim 4, wherein the OCV calculation unit is configured to calculate the OCV using at least one of the current data and the voltage data obtained using current and voltage measured at a time when the battery is substantially fully charged.

6. The battery management system of claim 5, wherein the OCV calculation unit is configured to calculate the OCV using at least one of the current data and the voltage data obtained using current and voltage measured at a time when the battery is in a state of being charged to 90% or more relative to a fully charged state of the battery.

7. The battery management system of any one of the preceding claims, wherein the sensing unit is further configured to obtain temperature data by measuring a battery temperature.

8. The battery management system of claim 7, wherein the OCV calculation unit is configured to determine the internal resistance using the temperature data obtained from the battery in a state in which a depth of discharge DOD of the battery is between about o and 0.85 and based on temperature-resistance relationship data stored in the controller and the internal resistance.

9. The battery management system of any one of the preceding claims when dependent on claim 4, wherein the controller further includes a current integration reset unit configured to reset the integrated current value to zero.

10. The battery management system of any one of the preceding claims when dependent on claim 4, wherein the SOC estimation unit is configured to estimate the SOC based on the calculated OCV and SOC-OCV relationship data stored in the SOC estimation unit.

11. The battery management system of any one of the preceding claims when dependent on claim 4, wherein, when the sum of absolute integrated current values does not exceed the predetermined value, the SOC estimation unit estimates the SOC using the integrated current value.

12. The battery management system of claim 11, wherein the SOC estimation unit estimates the SOC by adding the integrated current value to a predetermined initial SOC or a previously measured SOC.

13. The battery management system of any one of the preceding claims, wherein the predetermined value is between about five and seven times the battery capacity of the battery.

14. A method of using a battery management system, comprising:

receiving current data and voltage data of a battery;
calculating a sum of absolute integrated current values based on the current data;
calculating an open circuit voltage OCV upon determining that the sum of absolute integrated current values exceeds a predetermined value, using the current data, the voltage data and an internal resistance of the battery; and
estimating a state of charge SOC corresponding to the calculated OCV.

15. The method of claim 14, wherein calculating the sum of absolute integrated current values includes calculating an integrated current value by integrating the current data and/or
further comprising resetting the integrated current value to zero, when the sum of absolute integrated current values exceeds the predetermined value and/or
wherein at least one of the current data and voltage data for calculating the OCV is obtained using current or voltage measured at a time when the battery is substantially fully charged and/or
further comprising estimating the SOC using the integrated current value, when the sum of absolute integrated current values does not exceed the predetermined value.

# FIG. 1

# FIG. 2

20

# FIG. 3

**R vsDoD**

# FIG. 4

# FIG. 5

```
Receive current and voltage of battery          ─S501

Calculate integrated current value and          ─S503
sum of absolute integrated current values

                    S505
          Sum of absolute
      integrated current values          No
      > predetermined value?

              Yes

          Calculate OCV and reset           ─S507
          integrated current value

      Estimate SOC using OCV          Estimate SOC using
                                      integrated current value
              S509                              S511
```